(19) Europäisches Patentamt

European Patent Office

Office européen des brevets

(11) **EP 4 328 606 A1**

(12) **EUROPEAN PATENT APPLICATION**

(43) Date of publication:
**28.02.2024 Bulletin 2024/09**

(21) Application number: **22192185.1**

(22) Date of filing: **25.08.2022**

(51) International Patent Classification (IPC):
**G01R 31/72** [(2020.01)]    **F16K 31/02** [(2006.01)]
**F16K 37/00** [(2006.01)]

(52) Cooperative Patent Classification (CPC):
**G01R 31/72; F16K 31/0658; F16K 37/0041;**
G01R 27/08

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Siemens Schweiz AG
8047 Zürich (CH)**

(72) Inventors:
• **Beckers, Paul
52399 Merzenich (DE)**
• **Petry, Karl-Heinz
8864 Reichenburg (CH)**

(74) Representative: **Siemens Patent Attorneys
Postfach 22 16 34
80506 München (DE)**

(54) **CONTINUOUS IMPEDANCE AND/OR RESISTANCE MEASUREMENTS**

(57)    Continuous impedance and/or resistance measurements. A method of estimating an impedance of a winding (9a, 9b) inside an actuator (7, 8, 9a, 9b) of a valve (1), the method comprising: obtaining first readings of electric current through and of electric voltage applied to the actuator (7, 8, 9a, 9b) of the valve (1); after obtaining the first readings, sending a first signal to the actuator (7, 8, 9a, 9b) of the valve (1), the first signal causing the actuator (7, 8, 9a, 9b) to move to a first position; after sending the first signal, obtaining second readings of electric current through and of electric voltage applied to the actuator (7, 8, 9a, 9b) of the valve (1); then sending a second signal to the actuator (7, 8, 9a, 9b) of the valve (1), the second signal causing the actuator (7, 8, 9a, 9b) to move to a second position.

FIG 1

## Description

Background

The present disclosure relates to a continuous measurement of the electric impedance and/or resistance of a coil. More specifically, the electric impedance and/or resistance of a coil is determined while the coil is in operation. The coil can, by way of non-limiting example, be a coil of an actuator. It is also envisaged that the coil is a coil of an actuator of a valve.

Temperature rise tests of large power transformers according to IEC 60076-2, second edition, of April 1993, are conducted to estimate a maximum temperature inside the power transformer. To that end, the power transformer is operated at rated current for some time. The power transformer typically operates until temperature increases at a rate of less than one Kelvin per hour. The power transformer may also operate until temperature no longer rises.

When the rate of temperature rise is low enough or the temperature no longer rises, the power transformer is shut down. The leads for supplying the rated current to the power transformer are disconnected. A set of leads is connected to the power transformer to measure the electric resistance of the winding.

The measurement of electric resistance must be carried out shortly after the shutdown. The measurement is carried out by applying a direct electric current to the winding. That is, the measurement of the electric resistance of the winding of the power transformer is conducted with the power transformer not being in operation. Eventually, a temperature inside the power transformer is estimated based on the electric resistance measured shortly or immediately after the shutdown.

The practical difficulties of measuring the electric impedances and/or resistances of windings of actuators are exacerbated when the applied signal is not a direct current. The practical difficulties involved in such measurements of the electric impedances and/or resistances of windings of actuators can be further exacerbated when the applied voltage is non-sinusoidal. The applied voltage can, for example, be a pulse-width modulated signal. The shape of the applied signal over time then consists of rectangles or approximately consists of rectangles.

Also, the inductance of the actuator can change during operation. The poles of the rotating parts of the actuator will move past the coil and the inductance of the winding will vary accordingly.

Those issues are up to now resolved by application of a constant voltage to a coil of an actuator. For the duration of the measurement, the position of any moving part such as the position of a moveable anchor is kept constant. In other words, the actuator does not move.

A measurement of an electric current starts. The actual determination of the electric impedance and/or of the electric resistance of the coil is delayed until all or most transient effects have settled. Once the transient effects have settled, a measurement of electric current yields an estimate of the electric impedance and/or of the electric resistance of the coil. The temperature of the coil can eventually be estimated based on the electric resistance of the coil of the actuator. That procedure is somewhat unsatisfactory in that it does not afford estimates of coil temperature with the actuator in operation.

A Japanese patent application JPH03147532A was filed by SONY CORP on 1 November 1989. The application was published on 24 June 1991. JPH03147532A deals with an optical disc device.

The optical disc device of JPH03147532A comprises a laser and a lens for focusing a beam of the laser toward a rotating disc. A tracking actuator and a focusing actuator are used to control the focal point of the laser beam. Those actuators are, however, prone to failure due to burnout, excessive vibration, or the like. JPH03147532A is about monitoring the conditions of the actuators such as the condition of the tracking actuator.

To that end, a test voltage is applied to the actuator by a test voltage generator. A changeover switch operates before the test voltage can be applied. A controller then calculates the resistance of the actuator coil as a function of the terminal voltage of the actuator and the driving current. Since the temperature characteristic of the coil of the actuator is known, the temperature of the coil can also be calculated. Once the temperature has been calculated, it is compared to a threshold indicative of a permissible temperature. If the temperature exceeds the threshold, the entire optical disc device is taken out of operation. The changeover switch of JPH03147532A indicates that the resistance measurement is not carried out at operational voltages. Instead, the measurement is carried out using a test voltage. The test voltage is generated by the test generator for the purpose of testing the actuator.

It is desirable to obtain measurements of the electric impedances and/or of the electric resistances of coils of actuators with the actuators in operation. More specifically, it is desirable to obtain such measurements while applying operational voltages and without interruption of the normal operation of the actuator.

Summary

The present disclosure deals with measurements of electric impedances and/or electric resistances of windings of actuators of valves. The measurements shall preferably be carried out with the valve in operation. The measurements shall ideally be carried out while the actuator of the valve is moving. The actuator of the valve can move a valve member inside the valve. The winding of the actuator of the valve can, by way of non-limiting example, be at least one of

- a coil,
- a solenoid,

- a solenoid coil.

The winding of the actuator of the valve can, by way of other non-limiting examples, comprise at least one of

- a coil,
- a solenoid,
- a solenoid coil.

Accordingly, first readings are obtained indicative of a current through and of a voltage applied to an actuator of the valve. More specifically, first readings are obtained indicative of a current through and of a voltage applied to the winding of the actuator of the valve. When the first readings have been obtained, a first position signal is sent to the actuator. The first position signal causes the actuator to attain a first position. The first position signal can be a first actuation signal.

After the first position signal, second readings are obtained. The second readings are indicative of a current through and of a voltage applied to the actuator of the valve. The second readings are different from the first readings. The second readings are preferably obtained with the actuator in operation. That is, the second readings are obtained with the actuator moving.

A second position signal is then sent to the actuator. The second position signal causes the actuator to attain a second position. The second position signal can be a second actuation signal.

After the second position signal, third readings are obtained. The third readings are indicative of a current through and of a voltage applied to the actuator of the valve. The third readings are different from the first readings. The third readings are also different from the second readings. The third readings are preferably obtained with the actuator in operation. That is, the third readings are obtained with the actuator moving.

The first to third readings are used to produce first to third impedance values. The first to third readings can also be used to produce first to third resistance values. The impedance values are produced by relating the respective voltage readings to the respective current readings. More specifically, the impedance values are produced by dividing the respective voltage readings by the respective current readings. Likewise, resistance values can be produced by relating the respective voltage readings to the respective current readings. More specifically, resistance values can be produced by dividing the respective voltage readings by the respective current readings.

The values obtained from the readings vary. To mitigate variations, a filter such as

- a moving average filter,
- a simple moving average filter,
- a low-pass filter,
- a first-order low-pass filter

is applied. In so doing, an impedance of the winding of the actuator of the valve is estimated. Likewise, a resistance of the winding of the actuator of the valve can be estimated by filtering the resistance values.

More specifically, the filter functions to eliminate inductive parts of the impedance signal. Eventually, a resistance signal is produced by filtering the impedance signal.

According to an aspect of the present disclosure, the impedance of the winding and/or the resistance of the winding affords fault detection. If the impedance and/or the resistance is too large, the valve or parts of the valve will be de-energised. More specifically, the actuator and/or the winding of the actuator will be de-energised.

Estimates and/or determinations and/or calculations of (simple) moving averages can consume lots of computing power. To handle (simple) moving averages on systems with limited computational resources, application-specific integrated circuits can be employed. Application-specific integrated circuits afford computations of (simple) moving averages without requiring the excessive computational resources needed by general-purpose microcontrollers.

Brief description of the drawings

Various features will become apparent to those skilled in the art from the following detailed description of the disclosed non-limiting embodiments. The drawings that accompany the detailed description can be briefly described as follows:

FIG 1 is a schematic of a valve having a coil.

FIG 2 shows a coil connected to a source of electric power.

FIG 3 illustrates a controller in operative communication with a source and optionally with one or more meters.

Detailed description

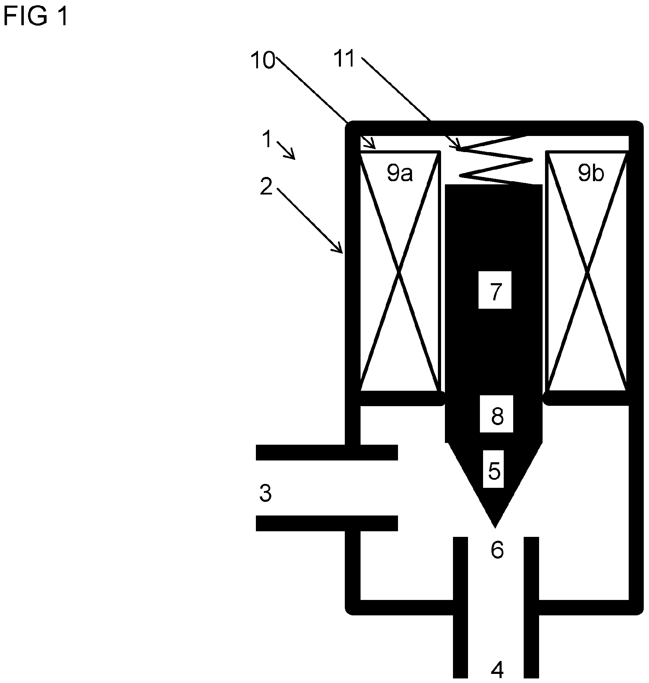

The instant disclosure deals with impedances and/or with resistances of coils. The coil can, by way of example, be a coil and/or a solenoid of a valve. FIG 1 shows the various components of a valve 1. The valve 1 advantageously is or comprises an expansion valve. Yet more advantageously the valve 1 is or comprises an electronic expansion valve. The valve 1 may be installed in a refrigeration-vapour circuit. The valve 1 in accordance with at least one embodiment is advantageously part of a refrigeration-vapour circuit.

The valve 1 comprises a housing 2. The valve housing 2 has sides defining a first port 3 and a second port 4. In an embodiment, the first port 3 comprises a first conduit. It is also envisaged that the second port 4 comprises a second conduit. According to an aspect of the instant disclosure, the first port 3 is an inlet port and the second port 4 is an outlet port 4. According to another aspect of the instant disclosure, the first port 3 is an outlet port and the second port 4 is an inlet port.

The first port 3 and the second port 4 are in fluid communication with each other to afford flow of a fluid through the valve 1. In a preferred embodiment, the fluid comprises a refrigerant. The fluid may, by way of non-limiting example, be a R32, R401A, R404A, R406A, R407A, R407C, R408A, R409A, R410A, R438A, R500, or a R502 refrigerant. The fluid at the inlet port advantageously is a liquid. The fluid at the outlet port preferably is a two-phase fluid.

A fluid path extends between the first port 3 and the second port 4. A valve member 5 is situated in the fluid path. The valve member 5 is moveable. The valve member 5 cooperates with a valve seat 6. The position of the valve member 5 thereby varies and limits a flow rate of the fluid through the valve 1.

It is envisaged that a valve body is or comprises the housing 2. In an embodiment, the housing 2 comprises a metallic material such as steel, especially austenitic (stainless) steel and/or ferrite steel. In an alternate embodiment, the housing 2 comprises aluminum (alloy) or gunmetal or brass. In yet another alternate embodiment, the housing 2 comprises a polymeric material. According to an aspect, the housing 2 is manufactured using an additive manufacturing technique such as three-dimensional printing. Manufacture of the housing 2 can, in a specific embodiment, involve selective laser sintering. It is still envisaged that the housing 2 comprises a grey cast material and/or of nodular cast iron.

According to an aspect of the present disclosure, a fluid conduit in between the first port 3 and the second port 4 is or comprises a polymeric member. It is also envisaged that manufacture of the fluid conduit and/or of the first port 3 and/or of the second port 4 involves additive manufacturing such as three-dimensional printing. Manufacture of the fluid conduit and/or of the first port 3 and/or of the second port 4 can involve selective laser sintering.

FIG 1 shows the valve seat 6 as part of the second port 4. The first port 3 can also comprise the valve seat 6. In an alternate embodiment, the valve seat 6 is separate from the first port 3. The valve seat 6 can also be separate from the second port 4.

In the embodiment shown in FIG 1, the valve member 5 is linearly moveable by linear movement of the armature 7. The armature 7 can mechanically connect to the valve member 5 via a stem 8. It is also envisaged that the armature 7 directly connects to the valve member 5.

According to an aspect of the present disclosure, the armature 7, the stem 8, and the valve member 5 form a single piece. That is, the stem 8 and the valve member 5 are both integral parts of the armature 7. Likewise, the armature 7 and the stem 8 are integral with the valve member 5.

According to another aspect of the present disclosure, the valve member 5 is configured to rotate to some extent with respect to the armature 7. The valve member 5 preferably rotates about an axis connecting the armature 7, the valve member 5, and/or the stem 8. In an embodiment, the valve member 5 is allowed to rotate by an articulation angle of 0.1 degrees or of 0.2 degrees or even of 0.5 degrees. A limited amount of articulation of the valve member 5 with respect to the armature 7 alleviates mechanical constraints.

At least a portion of the armature 7 can be surrounded by a coil 9a, 9b. Upon application of an electric current, the coil 9a, 9b produces a magnetic flux. This magnetic flux acts on the armature 7 thereby displacing the armature 7.

The coil 9a, 9b preferably comprises a solenoid 9a, 9b and/or a solenoid coil 9a, 9b. The coil 9a, 9b ideally is a solenoid 9a, 9b and/or a solenoid coil 9a, 9b.

A can needs not envelope the armature 7 and/or the stem 8. That is, the armature 7 has an outer surface. In an embodiment, a portion of the outer surface of the armature 7 directly faces the coil 9a, 9b. In another embodiment, the outer surface of the armature 7 directly faces the coil 9a, 9b. Likewise, the coil 9a, 9b has an outer surface. In an embodiment, a portion of the outer surface of the coil 9a, 9b directly faces the armature 7. In another embodiment, the outer surface of the coil 9a, 9b directly faces the armature 7.

The coil 9a, 9b and the armature 7 can be arranged in the same chamber 10 inside the housing 2. The chamber 10 is ideally filled with a liquid fluid. For example, the liquid fluid inside the chamber 10 can be a R401A, R404A, R406A, R407A, R407C, R408A, R409A, R410A, R438A, -500, or a R502 refrigerant.

A resilient member 11 ensures that the valve 1 is a normally closed valve. The resilient member 11 couples to the armature 7. In a specific embodiment, the resilient member 11 mechanically connects to the armature 7.

The resilient member 11 urges the armature 7 and the valve member 5 to close the valve 1. To that end, the resilient member 11 urges the armature 7 and the valve member 5 toward the seat 6. In a specific embodiment, the resilient member 11 urges the armature 7, the stem 8, and the valve member 5 to close the valve 1. To that end, the resilient member 11 urges the armature 7, the stem 8, and the valve member 5 toward the seat 6. The member 11 preferably urges these movable members 7a, 8, 5a toward the seat 6 until the valve member 5 engages the seat 6. The valve member 5 advantageously engages the seat 6 at a closed position.

According to an aspect, the resilient member 11 comprises a compression spring. The resilient member 11 can also be a compression spring. In a special embodiment, the resilient member 11 comprises a helical compression spring. The resilient member 11 can also be a helical compression spring.

The skilled person understands that a tension spring can be attached to the second port 4 and to the stem 8. The tension spring then urges the stem 8 toward the second port 4.

FIG 1 illustrates a valve having a linear actuator. The present disclosure also applies to valves 1 having rotating actuators. More specifically, the instant disclosure also applies to valves 1 having actuators in the form of stepper motors.

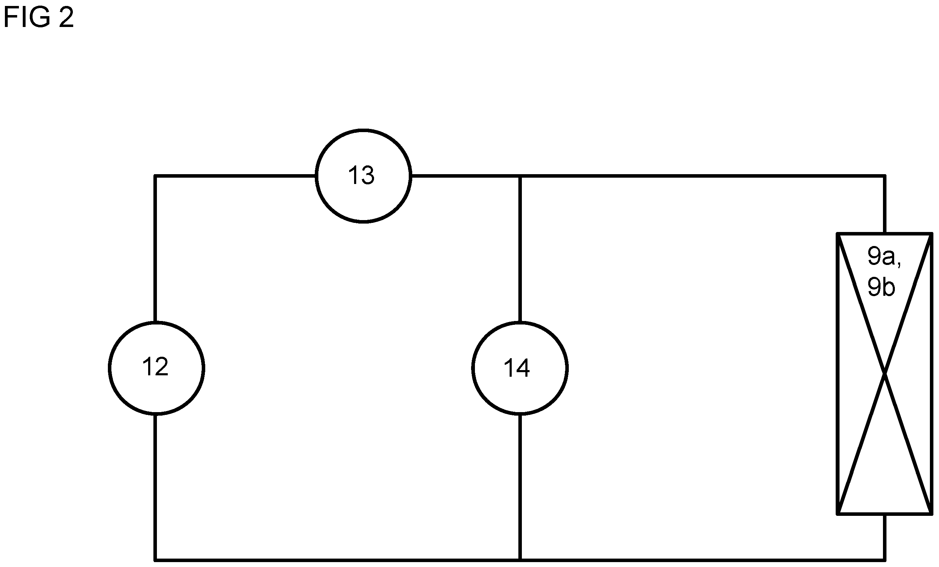

Now turning to FIG 2, the coil 9a, 9b connects to a source of electric power 12. In an embodiment, the source 12 provides an alternating electric current to the coil 9a, 9b. The alternating electric current can, by way of non-limiting example, be an alternating electric current at a frequency of 50 hertz or at a frequency of 60 hertz. The alternating electric current can, by way of another non-limiting example, the alternating electric current at a frequency of 400 hertz.

It is envisaged that the coil 9a, 9b comprises a solenoid 9a, 9b and/or a solenoid coil 9a, 9b. Consequently, the source 12 provides an alternating electric current to the solenoid 9a, 9b and/or to the solenoid coil 9a, 9b. The alternating electric current can, by way of non-limiting example, be an alternating electric current at a frequency of 50 hertz or at a frequency of 60 hertz. The alternating electric current can, by way of another non-limiting example, the alternating electric current at a frequency of 400 hertz.

It is still envisaged that the coil 9a, 9b is a solenoid 9a, 9b and/or is a solenoid coil 9a, 9b. Consequently, the source 12 provides an alternating electric current to the solenoid 9a, 9b and/or to the solenoid coil 9a, 9b. The alternating electric current can, by way of non-limiting example, be an alternating electric current at a frequency of 50 hertz or at a frequency of 60 hertz. The alternating electric current can, by way of another non-limiting example, the alternating electric current at a frequency of 400 hertz.

In another embodiment, the source 12 provides a direct electric current to the coil 9a, 9b. The direct electric current can, by way of non-limiting example, be applied at a voltage between 0 Volt and 3.3 Volts or between 0 Volt and 5 Volts. The direct electric current can, by way of another non-limiting example, be applied at a voltage between 0 Volt and 12 Volts or between 0 Volt and 24 Volts.

It is envisaged that the coil 9a, 9b comprises a solenoid 9a, 9b and/or a solenoid coil 9a, 9b. Consequently, the source 12 provides a direct electric current to the solenoid 9a, 9b and/or to the solenoid coil 9a, 9b. The direct electric current can, by way of non-limiting example, be applied at a voltage between 0 Volt and 3.3 Volts or between 0 Volt and 5 Volts. The direct electric current can, by way of another non-limiting example, be applied at a voltage between 0 Volt and 12 Volts or between 0 Volt and 24 Volts.

It is still envisaged that the coil 9a, 9b is a solenoid 9a, 9b and/or is a solenoid coil 9a, 9b. Consequently, the source 12 provides a direct electric current to the solenoid 9a, 9b and/or to the solenoid coil 9a, 9b. The direct electric current can, by way of non-limiting example, be applied at a voltage between 0 Volt and 3.3 Volts or between 0 Volt and 5 Volts. The direct electric current can, by way of another non-limiting example, be applied at a voltage between 0 Volt and 12 Volts or between 0 Volt and 24 Volts.

In yet another embodiment, the source 12 provides a pulse-width modulated signal to the coil 9a, 9b. The pulse-width modulated signal can be a pulse-width modulated electric current or a pulse-width modulated electric voltage. A pulse-width modulated electric current can be applied using a duty cycle such as ten percent or twenty percent or fifty percent. A pulse-width modulated electric voltage can also be applied using a duty cycle such as ten percent or twenty percent or fifty percent.

It is envisaged that the coil 9a, 9b comprises a solenoid 9a, 9b and/or a solenoid coil 9a, 9b. Consequently, the source 12 provides a pulse-width modulated signal to the solenoid 9a, 9b and/or to the solenoid coil 9a, 9b. The pulse-width modulated signal can be a pulse-width modulated electric current or a pulse-width modulated electric voltage. A pulse-width modulated electric current can be applied using a duty cycle such as ten percent or twenty percent or fifty percent. A pulse-width modulated electric voltage can also be applied using a duty cycle such as ten percent or twenty percent or fifty percent.

It is still envisaged that the coil 9a, 9b is a solenoid 9a, 9b and/or is a solenoid coil 9a, 9b. Consequently, the source 12 provides a pulse-width modulated signal to the solenoid 9a, 9b and/or to the solenoid coil 9a, 9b. The pulse-width modulated signal can be a pulse-width modulated electric current or a pulse-width modulated electric voltage. A pulse-width modulated electric current can be applied using a duty cycle such as ten percent or twenty percent or fifty percent. A pulse-width modulated electric voltage can also be applied using a duty cycle such as ten percent or twenty percent or fifty percent.

It is also envisaged that the coil 9a, 9b is a solenoid 9a, 9b and/or is a solenoid coil 9a, 9b. Consequently, the source 12 provides a pulse-width modulated signal to the solenoid 9a, 9b and/or to the solenoid coil 9a, 9b. The frequency of the pulse-width modulated signal can, by way of non-limiting example, exceed one kilohertz. The frequency of the pulse-width modulated signal can, by way of another non-limiting example, exceed one megahertz.

The source 12 applies an electric current to the coil 9a, 9b. The electric current as applied by the source 12 will flow between the terminals of the coil 9a, 9b. The electric current can be known because the source 12 is controlled such that it applies a given amount of electric current. The electric current through the coil 9a, 9b can also be recorded via a first meter 13. The first meter 13 preferably comprises a current meter such as an Ampere meter. The first meter 13 ideally is a current meter such as an Ampere meter. The first meter 13 is electrically connected in series with the source 12 and with the coil 9a, 9b.

It is envisaged that the coil 9a, 9b comprises a solenoid 9a, 9b and/or a solenoid coil 9a, 9b. The electric current can be known because the source 12 is controlled such that it applies a given amount of electric current. The electric current through the solenoid 9a, 9b and/or through the solenoid coil 9a, 9b can also be recorded via a first meter 13. The first meter 13 preferably comprises a current meter such as an Ampere meter. The first meter 13 ideally is a current meter such as an Ampere meter. The first meter 13 is electrically connected in series with the source 12 and with the coil 9a, 9b.

It is still envisaged that the coil 9a, 9b is a solenoid 9a, 9b and/or is a solenoid coil 9a, 9b. The electric current can be known because the source 12 is controlled such that it applies a given amount of electric current. The electric current through the solenoid 9a, 9b and/or through the solenoid coil 9a, 9b can also be recorded via a first meter 13. The first meter 13 preferably comprises a current meter such as an Ampere meter. The first meter 13 ideally is a current meter such as an Ampere meter. The first meter 13 is electrically connected in series with the source 12 and with the coil 9a, 9b.

The source 12 also applies an electric voltage to the coil 9a, 9b. The electric voltage as applied by the source 12 will be applied between the terminals of the coil 9a, 9b. The electric voltage can be known because the source 12 is controlled such that it applies a given electric voltage. The electric voltage applied between the terminals of the coil 9a, 9b can also be recorded via a second meter 14. The second meter 14 is advantageously different from the first meter 13. The second meter 14 preferably comprises a voltage meter. The second meter 14 ideally is a voltage meter. The second meter 14 is electrically connected in parallel with the source 12 and in parallel with the coil 9a, 9b.

It is envisaged that the coil 9a, 9b comprises a solenoid 9a, 9b and/or a solenoid coil 9a, 9b. The electric voltage between the terminals of the solenoid 9a, 9b and/or the solenoid coil 9a, 9b can be known because the source 12 is controlled. The source 12 is then controlled such that it applies a given electric voltage. The electric voltage applied between the terminals of the solenoid 9a, 9b and/or of the solenoid coil 9a, 9b can also be recorded via a second meter 14. The second meter 14 preferably comprises a voltage meter. The second meter 14 ideally is a voltage meter. The second meter 14 is electrically connected in parallel with the source 12 and in parallel with the coil 9a, 9b.

It is still envisaged that the coil 9a, 9b is a solenoid 9a, 9b and/or is a solenoid coil 9a, 9b. The electric voltage between the terminals of the solenoid 9a, 9b and/or the solenoid coil 9a, 9b can be known because the source 12 is controlled. The source 12 is then controlled such that it applies a given electric voltage. The electric voltage applied between the terminals of the solenoid 9a, 9b and/or of the solenoid coil 9a, 9b can also be recorded via a second meter 14. The second meter 14 preferably comprises a voltage meter. The second meter 14 ideally is a voltage meter. The second meter 14 is electrically connected in parallel with the source 12 and in parallel with the coil 9a, 9b.

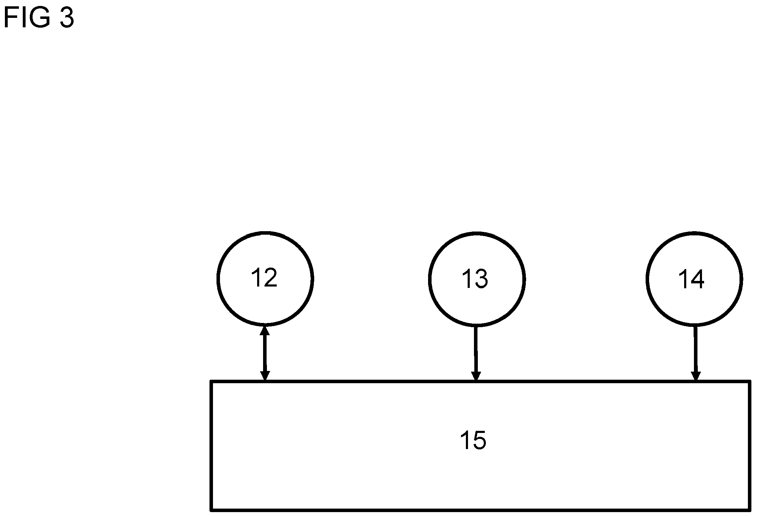

FIG 3 shows a controller 15. The controller 15 functions to relate the electric current through the coil 9a, 9b and the electric voltage applied to the coil 9a, 9b. That way, an electric resistance of the coil 9a, 9b can be estimated. Preferably, an electric resistance of the coil 9a, 9b can be determined. Ideally, an electric resistance of the coil 9a, 9b can be calculated.

It is envisaged that the coil 9a, 9b comprises a solenoid 9a, 9b and/or a solenoid coil 9a, 9b. The controller 15 then functions to relate at least one first electric signal and at least one second electric signal. The at least one first electric signal is the electric current through the solenoid 9a, 9b and/or through the solenoid coil 9a, 9b. The at least one second electric signal is the electric voltage applied to the solenoid 9a, 9b and/or to the solenoid coil 9a, 9b. That way, an electric resistance of the solenoid 9a, 9b and/or of the solenoid coil 9a, 9b can be estimated. Preferably, an electric resistance of the solenoid 9a, 9b and/or of the solenoid coil 9a, 9b can be determined. Ideally, an electric resistance of the solenoid 9a, 9b and/or of the solenoid coil 9a, 9b can be calculated.

It is still envisaged that the coil 9a, 9b is a solenoid 9a, 9b and/or is a solenoid coil 9a, 9b. The controller 15 then functions to relate at least one third electric signal and at least one fourth electric signal. The at least one third electric signal is the electric current through the solenoid 9a, 9b and/or through the solenoid coil 9a, 9b. The at least one fourth electric signal is the electric voltage applied to the solenoid 9a, 9b and/or to the solenoid coil 9a, 9b. That way, an electric resistance of the solenoid 9a, 9b and/or of the solenoid coil 9a, 9b can be estimated. Preferably, an electric resistance of the solenoid 9a, 9b and/or of the solenoid coil 9a, 9b can be determined. Ideally, an electric resistance of the solenoid 9a, 9b and/or of the solenoid coil 9a, 9b can be calculated.

The controller 15 advantageously comprises a microcontroller and/or a microprocessor. In an embodiment, the controller 15 is a microcontroller and/or is a microprocessor. The controller 15 preferably comprises a memory such as a non-volatile memory.

FIG 3 shows a connection between the controller 15 and the source 12. The connection between the controller 15 and the source 12 can be bidirectional. A bidirectional connection affords flexibility. For example, the source 12 can be controlled via by the controller 15 using closed-loop control. The source 12 can then send feedback signals to the controller 15. The connection between the controller 15 and the source 12 can also be unidirectional. Communication from the controller 15 to the source 12 is afforded by such a unidirectional connection. A unidirectional connection reduces complexity.

In an embodiment, the controller 15 controls the source 12 and the source 12 applies an electric current through the coil 9a, 9b. The electric current through the coil 9a, 9b is defined by an output signal of the controller 15. The controller 15 also controls the source 12 and the source applies an electric voltage between the terminals of the coil 9a, 9b. The electric voltage between the terminals of the coil 9a, 9b is also defined by an output signal of the controller 15. In consequence of the controlled output currents and controlled output voltages, the meters 13, 14 are optional.

It is envisaged that the coil 9a, 9b comprises a solenoid 9a, 9b and/or a solenoid coil 9a, 9b. The controller 15 controls the source 12 and the source 12 applies an electric current through the solenoid 9a, 9b and/or through the solenoid coil 9a, 9b. The electric current through the solenoid 9a, 9b and/or through the solenoid coil 9a, 9b is defined by an output signal of the controller 15. The controlled source 12 also applies an electric voltage between the terminals of the solenoid 9a, 9b and/or of the solenoid coil 9a, 9b. The electric voltage between the terminals of the solenoid 9a, 9b and/or of the solenoid coil 9a, 9b is defined by an output of the controller 15. In consequence of the controlled output currents and controlled output voltages, the meters 13, 14 are optional.

It is still envisaged that the coil 9a, 9b is a solenoid 9a, 9b and/or is a solenoid coil 9a, 9b. The controller 15 controls the source 12 and the source 12 applies an electric current through the solenoid 9a, 9b and/or through the solenoid coil 9a, 9b. The electric current through the solenoid 9a, 9b and/or through the solenoid coil 9a, 9b is defined by an output signal of the controller 15. The controlled source 12 also applies an electric voltage between the terminals of the solenoid 9a, 9b and/or of the solenoid coil 9a, 9b. The electric voltage between the terminals of the solenoid 9a, 9b and/or of the solenoid coil 9a, 9b is defined by an output of the controller 15. In consequence of the controlled output currents and controlled output voltages, the meters 13, 14 are optional.

In another embodiment, the electric currents and/or electric voltages are not known by virtue of a controlled source 12. Meters 13, 14 can then be necessary to obtain readings of electric current and/or of electric voltage.

FIG 3 shows a connection between the controller 15 and the first meter 13. The connection between the controller 15 and the first meter 13 can be bidirectional. A bidirectional connection affords flexibility. The connection between the controller 15 and the first meter 13 can also be unidirectional. Communication from the first meter 13 to the controller 15 is facilitated by such a unidirectional connection. A unidirectional connection reduces complexity.

In a compact embodiment, the controller 15 comprises a first analog-to-digital converter. The first analog-to-digital converter provides conversion of analog signals from the first meter 13 into (digital) measures. The first analog-to-digital converter can be an integral part of the controller 15. That is, the first analog-to-digital converter and the controller 15 are arranged on the same system-on-a-chip.

FIG 3 also shows a connection between the controller 15 and the second meter 14. The connection between the controller 15 and the second meter 14 can be bidirectional. A bidirectional connection affords flexibility. The connection between the controller 15 and the second meter 14 can also be unidirectional. Communication from the second meter 14 to the controller 15 is facilitated by such a unidirectional connection. A unidirectional connection reduces complexity.

In a compact embodiment, the controller 15 comprises a second analog-to-digital converter. The second analog-to-digital converter provides conversion of analog signals from the second meter 14 into (digital) measures. The second analog-to-digital converter can be an integral part of the controller 15. That is, the second analog-to-digital converter and the controller 15 are arranged on the same system-on-a-chip.

In an embodiment, the first analog-to-digital converter and the second analog-to-digital converter are the same. By using the same analog-to-digital converter for different meters 13, 14, the solution becomes more compact. Also, the solution avoids extra analog-to-digital converters that are prone to failure. In an alternate embodiment, the first analog-to-digital converter is different from the second analog-to-digital converter.

The controller 15 advantageously comprises at least one arithmetic logic unit (ALU). The controller 15 uses the one or more arithmetic logic units to perform computations. The controller 15 can, by way of non-limiting example, use the one or more arithmetic logic units to relate a first quantity to a second quantity. In an embodiment, the first quantity is a voltage applied between the terminals of the coil 9a, 9b. In another embodiment, that quantity is a voltage between the terminals of the solenoid 9a, 9b or between the terminals of the solenoid coil 9a, 9b. In an embodiment, the second quantity is an electric current through the coil 9a, 9b. In another embodiment, the second quantity is an electric current through the solenoid 9a, 9b or through the solenoid coil 9a, 9b. The controller 15 can, by way of another non-limiting example, use the one or more arithmetic logic units to divide a first quantity by a second quantity. In an embodiment, the first quantity is a voltage applied between the terminals of the coil 9a, 9b. In another embodiment, that quantity is a voltage between the terminals of the solenoid 9a, 9b or between the terminals of the solenoid coil 9a, 9b. In an embodiment, the second quantity is an electric current through the coil 9a, 9b. In another embodiment, the second quantity is an electric current through the solenoid 9a, 9b or through the solenoid coil 9a, 9b.

The controller 15 obtains a first series of readings, each reading being indicative of an electric voltage applied between the terminals of the coil 9a, 9b. The first series of readings is obtained with the valve 1 in operation. The first series of readings can be obtained with the armature 7 of the valve 1 moving.

The controller 15 also obtains a second series of readings, each reading being indicative of an electric current through the coil 9a, 9b. The second series of readings is obtained with the valve 1 in operation. The second series of readings can be obtained with the armature 7 of the valve 1 moving.

It is envisaged that every reading of the first series corresponds to a reading of the second series. There is a reading of a voltage applied between the terminals of the coil 9a, 9b for every reading of a current through the coil 9a, 9b. Preferably, individual readings of the first series and of the second series are obtained substantially at the same time. Ideally, individual readings of the first series and of the second series are obtained at the same time.

According to an aspect of the present disclosure, the coil 9a, 9b comprises a solenoid 9a, 9b and/or a solenoid coil 9a, 9b. The controller 15 obtains a first series of readings. Each reading is indicative of an electric voltage applied between the terminals of the solenoid 9a, 9b or of the solenoid coil 9a, 9b. The first series of readings is obtained with the valve 1 in operation. The first series of readings can be obtained with the armature 7 of the valve 1 moving.

The controller 15 also obtains a second series of readings, each reading being indicative of an electric current through the solenoid 9a, 9b or through the solenoid coil 9a, 9b. The second series of readings is obtained with the valve 1 in operation. The second series of readings can be obtained with the armature 7 of the valve 1 moving.

It is envisaged that every reading of the first series corresponds to a reading of the second series. There is a reading of a voltage applied between the terminals of the solenoid 9a, 9b for every reading of a current through the solenoid 9a, 9b. Likewise, there is a voltage reading between the terminals of the solenoid coil 9a, 9b for every reading of a current through the solenoid coil 9a, 9b. Preferably, individual readings of the first series and of the second series are obtained substantially at the same time. Ideally, individual readings of the first series and of the second series are obtained at the same time.

According to another aspect of the present disclosure, the coil 9a, 9b is a solenoid 9a, 9b and/or is a solenoid coil 9a, 9b. The controller 15 obtains a first series of readings. Each reading is indicative of an electric voltage applied between the terminals of the solenoid 9a, 9b or of the solenoid coil 9a, 9b. The first series of readings is obtained with the valve 1 in operation. The first series of readings can be obtained with the armature 7 of the valve 1 moving.

The controller 15 also obtains a second series of readings, each reading being indicative of an electric current through the solenoid 9a, 9b or through the solenoid coil 9a, 9b. The second series of readings is obtained with the valve 1 in operation. The second series of readings can be obtained with the armature 7 of the valve 1 moving.

It is envisaged that every reading of the first series corresponds to a reading of the second series. There is a reading of a voltage applied between the terminals of the solenoid 9a, 9b for every reading of a current through the solenoid 9a, 9b. Likewise, there is a voltage reading between the terminals of the solenoid coil 9a, 9b for every reading of a current through the solenoid coil 9a, 9b. Preferably, individual readings of the first series and of the second series are obtained substantially at the same time. Ideally, individual readings of the first series and of the second series are obtained at the same time.

The controller 15 then produces a third series from the first and second series. In so doing, the controller 15 relates the readings of the first series to the readings of the second series. More specifically, the controller 15 iterates the readings of the first series. Individual readings of the first series are related to individual readings of the second series. The controller 15 can also iterate the readings of the second series. Individual readings of the first series are related to individual readings of the second series.

The third series preferably comprises values of electric impedance. An impedance value of the third series is obtained by relating a voltage reading of the first series to a current reading of the second series. In so doing, the voltage reading of the first series advantageously corresponds to the current reading of the second series. That is, the reading of electric voltage and the reading of electric current have been recorded substantially at the same time. The reading of electric voltage and the reading of electric current can even have been recorded at the same time.

The values of impedance obtained from the first and second series can fluctuate over time. To mitigate fluctuations, a filter can be applied. Filtered values $y_m$ are obtained from the values of impedance $x_k$ of the third series:

$$y_m = \sum_k x_k f_{m-k}$$

More specifically, a third series having N values of impedance $x_k$ can be filtered

$$y_m = \sum_{k=0}^{N-1} x_k f_{(m-k)\bmod N}$$

The filter can, by way of example, be a moving average filter such as a simple moving average filter. The controller 15 can, by way of non-limiting example, comprise an application-specific integrated circuit for calculating moving averages. The controller 15 can, by way of another non-limiting example, comprise an application-specific integrated circuit for calculating simple moving averages. Application-specific integrated circuits afford effective and power-saving calculations of moving averages and of simple moving averages. The filter can, by way of another example, also be a low-pass filter such as a first order low-pass filter.

The filter can have a time constant. Time constants of at least fifteen seconds or of at least thirty seconds or of at least fifty seconds afford effective mitigation of fluctuations.

The filtered values $y_m$ can form a fourth series. Corrective action can be taken based on the filtered values $y_m$. For example, a coil 9a, 9b can be de-energised in the event of excessive filtered values $s_m$. That is, the coil 9a, 9b will be de-energised if any of the filtered values $y_m$ exceeds a threshold v. The threshold v can be a predetermined threshold. Likewise, a solenoid 9a, 9b or a solenoid coil 9a, 9b can be de-energised in the event of excessive filtered values $y_m$. That is, the solenoid 9a, 9b or the solenoid coil 9a, 9b will be de-energised if any of the filtered values $y_m$ exceeds a threshold v. The threshold v can be a predetermined threshold.

The third series ideally comprises values of electric resistance. A resistance value of the third series is obtained by relating a voltage reading of the first series to a current reading of the second series. In so doing, the voltage reading of the first series advantageously corresponds to the current reading of the second series. That is, the reading of electric voltage and the reading of electric current have been recorded substantially at the same time. The reading of electric voltage and the reading of electric current can even have been recorded at the same time.

The controller 15 can also divide readings of the first series by readings of the second series. The controller 15 can, by way of non-limiting example, use the one or more arithmetic logic units of the controller 15 to perform the division. More specifically, the controller 15 iterates the readings of the first series. Individual readings of the first series are divided by individual readings of the second series. The controller 15 can also iterate the readings of the second series. Individual readings of the first series are divided by individual readings of the second series.

The third series advantageously comprises values of electric impedance. An impedance value of the third series is obtained by dividing a voltage reading of the first series by a current reading of the second series. In so doing, the voltage reading of the first series advantageously corresponds to the current reading of the second series. That is, the reading of electric voltage and the reading of electric current have been recorded substantially at the same time. The reading of electric voltage and the reading of electric current can even have been recorded at the same time. The controller 15 can, by way of non-limiting example, use the one or more arithmetic logic units of the controller 15 to perform these divisions.

The third series ideally comprises values of electric resistance. A resistance value of the third series is obtained by dividing a voltage reading of the first series by a current reading of the second series. In so doing, the voltage reading of the first series advantageously corresponds to the current reading of the second series. That is, the reading of electric voltage and the reading of electric current have been recorded substantially at the same time. The reading of electric voltage and the reading of electric current can even have been recorded at the same time. The controller 15 can, by way of non-limiting example, use the one or more arithmetic logic units of the controller 15 to perform these divisions.

The values of resistance obtained from the first and second series can fluctuate over time. To mitigate fluctuations, a filter can be applied. Filtered values $s_m$ are obtained from the values of resistance $r_k$ of the third series:

$$ s_m = \sum_k r_k f_{m-k} $$

More specifically, a third series having N values of resistance $r_k$ can be filtered

$$ s_m = \sum_{k=0}^{N-1} r_k f_{(m-k) \bmod N} $$

The filter can, by way of example, be a moving average filter such as a simple moving average filter. The controller 15 can, by way of non-limiting example, comprise an application-specific integrated circuit for calculating moving averages. The controller 15 can, by way of another non-limiting example, comprise an application-specific integrated circuit for calculating simple moving averages. Application-specific integrated circuits afford effective and power-saving calculations of moving averages and of simple moving averages. The filter can, by way of another example, also be a low-pass filter such as a first order low-pass filter.

The filter can have a time constant. Time constants of at least fifteen seconds or of at least thirty seconds or of at least fifty seconds afford effective mitigation of fluctuations.

The filtered values $s_m$ can form a fourth series. Corrective action can be taken based on the filtered values $s_m$. For example, a coil 9a, 9b can be de-energised in the event of excessive filtered values $s_m$. That is, the coil 9a, 9b will be de-energised if any of the filtered values $s_m$ exceeds a threshold t. The threshold t can be a predetermined threshold. Likewise, a solenoid 9a, 9b or a solenoid coil 9a, 9b can be de-energised in the event of excessive filtered values $s_m$. That is, the solenoid 9a, 9b or the solenoid coil 9a, 9b will be de-energised if any of the filtered values $s_m$ exceeds a threshold t. The threshold t can be a predetermined threshold.

As described in detail herein, the present disclosure deals with a method of estimating an impedance of a winding (9a, 9b) inside an actuator (7, 8, 9a, 9b) of a valve (1), the method comprising the steps of:

obtaining first readings of electric current through and of electric voltage applied to the actuator (7, 8, 9a, 9b) of the valve (1);

after obtaining the first readings, sending a first position signal to the actuator (7, 8, 9a, 9b) of the valve (1), the first position signal causing the actuator (7, 8, 9a, 9b) to move to a first position;

after sending the first position signal, obtaining second readings of electric current through and of electric voltage applied to the actuator (7, 8, 9a, 9b) of the valve (1);

after obtaining the second readings, sending a second position signal to the actuator (7, 8, 9a, 9b) of the valve (1), the second position signal causing the actuator (7, 8, 9a, 9b) to move to a second position;

after sending the second position signal, obtaining third readings of electric current through and of electric voltage applied to the actuator (7, 8, 9a, 9b) of the valve (1);

producing a first impedance value from the first readings;

producing a second impedance value from the second readings;

producing a third impedance value from the third readings; and

estimating an impedance of the winding (9a, 9b) inside the actuator (7, 8, 9a, 9b) of the valve (1) by applying a filter to the first, second, and third impedance values.

The method of estimating an impedance of a winding (9a, 9b) inside an actuator (7, 8, 9a, 9b) of a valve (1) advantageously is a method of determining an impedance of a winding (9a, 9b) inside an actuator (7, 8, 9a, 9b) of a valve (1). Accordingly, the method comprises the step of determining an impedance of the winding (9a, 9b) inside the actuator (7, 8, 9a, 9b) of the valve (1) by applying a filter to the first, second, and third impedance values. The method of estimating an impedance of a winding (9a, 9b) inside an actuator (7, 8, 9a, 9b) of a valve (1) ideally is a method of calculating an impedance of a winding (9a, 9b) inside an actuator (7, 8, 9a, 9b) of a valve (1). Accordingly, the method comprises the step of calculating an impedance of the winding (9a, 9b) inside the actuator (7, 8, 9a, 9b) of the valve (1) by applying a filter to the first, second, and third impedance values.

It is envisaged that the first, second, and third impedance values are real values. That is, the first impedance value is a first resistance value. The second impedance value is a second resistance value. The third impedance value is a third resistance value. It is still envisaged that the impedance of the winding (9a, 9b) inside the actuator (7, 8, 9a, 9b) of the valve (1) is real. That is, the impedance of the winding (9a, 9b) inside the actuator (7, 8, 9a, 9b) of the valve (1) is a resistance of the winding (9a, 9b) inside the actuator (7, 8, 9a, 9b) of the valve (1).

The method preferably comprises the steps of:

obtaining first readings of electric current through and of electric voltage applied to the winding (9a, 9b) inside the actuator (7, 8, 9a, 9b) of the valve (1);

after sending the first position signal, obtaining second readings of electric current through and of electric voltage applied to the winding (9a, 9b) inside the actuator (7, 8, 9a, 9b) of the valve (1); and

after sending the second position signal, obtaining third readings of electric current through and of electric voltage applied to the winding (9a, 9b) inside the actuator (7, 8, 9a, 9b) of the valve (1).

The first position is preferably different from the second position. It is envisaged that the first position is a first position of the actuator (7, 8, 9a, 9b) of the valve (1). It is also envisaged that the second position is a second position of the actuator (7, 8, 9a, 9b) of the valve (1). The first position of the actuator (7, 8, 9a, 9b) of the valve (1) is preferably different from the second position of the actuator (7, 8, 9a, 9b) of the valve (1).

The method advantageously comprises the steps of:

determining a first impedance value from the first readings by dividing the reading of electric voltage of the first readings by the reading of electric current of the first readings;

determining a second impedance value from the second readings by dividing the reading of electric voltage of the second readings by the reading of electric current of the second readings; and

determining a third impedance value from the third readings by dividing the reading of electric voltage of the third readings by the reading of electric current of the third readings.

The method ideally comprises the steps of:

calculating a first impedance value from the first readings by dividing the reading of electric voltage of the first readings by the reading of electric current of the first readings;

calculating a second impedance value from the second readings by dividing the reading of electric voltage of the second readings by the reading of electric current of the second readings; and

calculating a third impedance value from the third readings by dividing the reading of electric voltage of the third readings by the reading of electric current of the third readings.

The instant disclosure also deals with any of the aforementioned methods, the method comprising the step of:
after sending the first position signal and while the actuator (7, 8, 9a, 9b) is moving to the first position, obtaining the second readings of electric current through and of electric voltage applied to the actuator (7, 8, 9a, 9b) of the valve (1).

The present disclosure still deals with any of the aforementioned methods, the method comprising the step of:
after sending the first position signal and while the actuator (7, 8, 9a, 9b) is moving to the first position, obtaining the second readings of electric current through and of electric voltage applied to the winding (9a, 9b) inside the actuator (7, 8, 9a, 9b) of the valve (1).

The instant disclosure also deals with any of the aforementioned methods, the method comprising the step of:
after sending the second position signal and while the actuator (7, 8, 9a, 9b) is moving to the second position, obtaining the third readings of electric current through and of electric voltage applied to the actuator (7, 8, 9a, 9b) of the valve (1).

The present disclosure still deals with any of the aforementioned methods, the method comprising the step of:
after sending the second position signal and while the actuator (7, 8, 9a, 9b) is moving to the second position, obtaining the third readings of electric current through and of electric voltage applied to the winding (9a, 9b) inside the actuator (7, 8, 9a, 9b) of the valve (1).

The instant disclosure further deals with any of the aforementioned methods, the method comprising the steps of:

after sending the first position signal and while the actuator (7, 8, 9a, 9b) is moving to the first position, obtaining the second readings of electric current through and of electric voltage applied to the actuator (7, 8, 9a, 9b) of the valve (1); and
after sending the second position signal and while the actuator (7, 8, 9a, 9b) is moving to the second position, obtaining the third readings of electric current through and of electric voltage applied to the actuator (7, 8, 9a, 9b) of the valve (1).

The present disclosure yet further deals with any of the aforementioned methods, the method comprising the steps of:

after sending the first position signal and while the actuator (7, 8, 9a, 9b) is moving to the first position, obtaining the second readings of electric current through and of electric voltage applied to the winding (9a, 9b) inside the actuator (7, 8, 9a, 9b) of the valve (1); and
after sending the second position signal and while the actuator (7, 8, 9a, 9b) is moving to the second position, obtaining the third readings of electric current through and of electric voltage applied to the winding (9a, 9b) inside the actuator (7, 8, 9a, 9b) of the valve (1).

The instant disclosure also deals with any of the aforementioned methods, the method comprising the step of:
estimating the impedance of the winding (9a, 9b) inside the actuator (7, 8, 9a, 9b) of the valve (1) by applying a low-pass filter to the first, second, and third impedance values.

The instant disclosure still deals with any of the aforementioned methods, the method comprising the step of:
estimating the impedance of the winding (9a, 9b) inside the actuator (7, 8, 9a, 9b) of the valve (1) by applying a first-order low-pass filter to the first, second, and third impedance values.

The present disclosure also deals with any of the aforementioned methods, the method comprising the step of:
determining the impedance of the winding (9a, 9b) inside the actuator (7, 8, 9a, 9b) of the valve (1) by applying a low-pass filter to the first, second, and third impedance values.

The instant disclosure still deals with any of the aforementioned methods, the method comprising the step of:
calculating the impedance of the winding (9a, 9b) inside the actuator (7, 8, 9a, 9b) of the valve (1) by applying a low-pass filter to the first, second, and third impedance values.

The present disclosure further deals with any of the aforementioned methods, the method comprising the step of:
determining the impedance of the winding (9a, 9b) inside the actuator (7, 8, 9a, 9b) of the valve (1) by applying a first-order low-pass filter to the first, second, and third impedance values.

The instant disclosure still further deals with any of the aforementioned methods, the method comprising the step of:
calculating the impedance of the winding (9a, 9b) inside the actuator (7, 8, 9a, 9b) of the valve (1) by applying a first-order low-pass filter to the first, second, and third impedance values.

The present disclosure also deals with any of the aforementioned methods not explicitly involving a low-pass filter, the method comprising the step of:
estimating the impedance of the winding (9a, 9b) inside the actuator (7, 8, 9a, 9b) of the valve (1) by applying a moving average filter to the first, second, and third impedance values.

The instant disclosure still deals with any of the aforementioned methods not explicitly involving a low-pass filter, the method comprising the step of:

estimating the impedance of the winding (9a, 9b) inside the actuator (7, 8, 9a, 9b) of the valve (1) by applying a simple moving average filter to the first, second, and third impedance values.

The present disclosure also deals with any of the aforementioned methods not explicitly involving a low-pass filter, the method comprising the step of:

determining the impedance of the winding (9a, 9b) inside the actuator (7, 8, 9a, 9b) of the valve (1) by applying a moving average filter to the first, second, and third impedance values.

The instant disclosure still deals with any of the aforementioned methods not explicitly involving a low-pass filter, the method comprising the step of:

calculating the impedance of the winding (9a, 9b) inside the actuator (7, 8, 9a, 9b) of the valve (1) by applying a moving average filter to the first, second, and third impedance values.

The present disclosure further deals with any of the aforementioned methods not explicitly involving a low-pass filter, the method comprising the step of:

determining the impedance of the winding (9a, 9b) inside the actuator (7, 8, 9a, 9b) of the valve (1) by applying a simple moving average filter to the first, second, and third impedance values.

The instant disclosure still further deals with any of the aforementioned methods not explicitly involving a low-pass filter, the method comprising the step of:

calculating the impedance of the winding (9a, 9b) inside the actuator (7, 8, 9a, 9b) of the valve (1) by applying a simple moving average filter to the first, second, and third impedance values.

The present disclosure also deals with any of the aforementioned methods, the method comprising the steps of:

comparing the impedance of the winding (9a, 9b) inside the actuator (7, 8, 9a, 9b) of the valve (1) to a threshold value; and
if the impedance of the winding (9a, 9b) inside the actuator (7, 8, 9a, 9b) of the valve (1) is larger than the threshold value:
interrupting supply of electric power to the actuator (7, 8, 9a, 9b) of the valve (1).

The instant disclosure still deals with any of the aforementioned methods, the method comprising the steps of:

comparing the impedance of the winding (9a, 9b) inside the actuator (7, 8, 9a, 9b) of the valve (1) to a predetermined threshold value; and
if the impedance of the winding (9a, 9b) inside the actuator (7, 8, 9a, 9b) of the valve (1) is larger than the predetermined threshold value:
interrupting supply of electric power to the actuator (7, 8, 9a, 9b) of the valve (1).

The present disclosure still further deals with any of the aforementioned methods, the method comprising the step of:

determining a temperature of the winding (9a, 9b) inside the actuator (7, 8, 9a, 9b) of the valve (1) as a function of the impedance of the winding (9a, 9b) inside the actuator (7, 8, 9a, 9b) of the valve (1).

The instant disclosure yet further deals with any of the aforementioned methods, the method comprising the step of:

calculating a temperature of the winding (9a, 9b) inside the actuator (7, 8, 9a, 9b) of the valve (1) as a function of the impedance of the winding (9a, 9b) inside the actuator (7, 8, 9a, 9b) of the valve (1).

The present disclosure still further deals with any of the aforementioned methods, the method comprising the step of:

determining a temperature of the winding (9a, 9b) inside the actuator (7, 8, 9a, 9b) of the valve (1) as a function of the impedance of the winding (9a, 9b) inside the actuator (7, 8, 9a, 9b) of the valve (1).

The instant disclosure also deals with any of the aforementioned methods involving a temperature of the winding (9a, 9b) inside the actuator (7, 8, 9a, 9b) of the valve (1), the method comprising the steps of:

comparing the temperature of the winding (9a, 9b) inside the actuator (7, 8, 9a, 9b) of the valve (1) to a temperature threshold value; and
if the temperature of the winding (9a, 9b) inside the actuator (7, 8, 9a, 9b) of the valve (1) is larger than the temperature threshold value:
interrupting supply of electric power to the actuator (7, 8, 9a, 9b) of the valve (1).

The present disclosure further deals with any of the aforementioned methods involving a temperature of the winding (9a, 9b) inside the actuator (7, 8, 9a, 9b) of the valve (1), the method comprising the steps of:

comparing the temperature of the winding (9a, 9b) inside the actuator (7, 8, 9a, 9b) of the valve (1) to a predetermined temperature threshold value; and
if the temperature of the winding (9a, 9b) inside the actuator (7, 8, 9a, 9b) of the valve (1) is larger than the predetermined temperature threshold value:
interrupting supply of electric power to the actuator (7, 8, 9a, 9b) of the valve (1).

The present disclosure also deals with any of the aforementioned methods, the method comprising the steps of:

comparing the impedance of the winding (9a, 9b) inside the actuator (7, 8, 9a, 9b) of the valve (1) to a threshold value; and
if the impedance of the winding (9a, 9b) inside the actuator (7, 8, 9a, 9b) of the valve (1) is larger than the threshold value:
interrupting supply of electric power to the winding (9a, 9b) inside the actuator (7, 8, 9a, 9b) of the valve (1).

The instant disclosure further deals with any of the aforementioned methods, the method comprising the steps of:

comparing the impedance of the winding (9a, 9b) inside the actuator (7, 8, 9a, 9b) of the valve (1) to a predetermined threshold value; and
if the impedance of the winding (9a, 9b) inside the actuator (7, 8, 9a, 9b) of the valve (1) is larger than the predetermined threshold value:
interrupting supply of electric power to the winding (9a, 9b) inside the actuator (7, 8, 9a, 9b) of the valve (1).

The present disclosure still deals with a valve (1) comprising an actuator (7, 8, 9a, 9b) having a winding (9a, 9b), a valve member (5) mechanically coupled to the actuator (7, 8, 9a, 9b), a controller (15) in operative communication with the actuator (7, 8, 9a, 9b), wherein the controller (15) is configured to:

obtain first readings of electric current through and of electric voltage applied to the winding (9a, 9b) of the actuator (7, 8, 9a, 9b) of the valve (1);
after obtaining the first readings, send a first position signal to the actuator (7, 8, 9a, 9b) of the valve (1), the first position signal causing the actuator (7, 8, 9a, 9b) to move to a first position;
after sending the first position signal, obtain second readings of electric current through and of electric voltage applied to the winding (9a, 9b) of the actuator (7, 8, 9a, 9b) of the valve (1);
after obtaining the second readings, send a second position signal to the actuator (7, 8, 9a, 9b) of the valve (1), the second position signal causing the actuator (7, 8, 9a, 9b) to move to a second position;
after sending the second position signal, obtain third readings of electric current through and of electric voltage applied to the winding (9a, 9b) of the actuator (7, 8, 9a, 9b) of the valve (1);
produce a first impedance value from the first readings;
produce a second impedance value from the second readings;
produce a third impedance value from the third readings; and
estimate an impedance of the winding (9a, 9b) of the actuator (7, 8, 9a, 9b) of the valve (1) by applying a filter to the first, second, and third impedance values.

The controller (15) is preferably configured to determine an impedance of the winding (9a, 9b) of the actuator (7, 8, 9a, 9b) of the valve (1) by applying a filter to the first, second, and third impedance values. The controller (15) is ideally configured to calculate an impedance of the winding (9a, 9b) of the actuator (7, 8, 9a, 9b) of the valve (1) by applying a filter to the first, second, and third impedance values.

It is envisaged that the first, second, and third impedance values are real values. That is, the first impedance value is a first resistance value. The second impedance value is a second resistance value. The third impedance value is a third resistance value. It is still envisaged that the impedance of the winding (9a, 9b) of the actuator (7, 8, 9a, 9b) of the valve (1) is real. That is, the impedance of the winding (9a, 9b) of the actuator (7, 8, 9a, 9b) of the valve (1) is a resistance of the winding (9a, 9b) of the actuator (7, 8, 9a, 9b) of the valve (1).

The first position is preferably different from the second position. It is envisaged that the first position is a first position of the actuator (7, 8, 9a, 9b) of the valve (1). It is also envisaged that the second position is a second position of the actuator (7, 8, 9a, 9b) of the valve (1). The first position is advantageously associated also with a first position of the valve member (5). The second position is advantageously associated also with a second position of the valve member (5). The first position of the actuator (7, 8, 9a, 9b) of the valve (1) is preferably different from the second position of the actuator (7, 8, 9a, 9b) of the valve (1).

The present disclosure also deals with any of the aforementioned valves (1), wherein the controller (15) is configured to:

determine a first impedance value from the first readings by dividing the reading of electric voltage of the first readings by the reading of electric current of the first readings;
determine a second impedance value from the second readings by dividing the reading of electric voltage of the second readings by the reading of electric current of the second readings; and
determine a third impedance value from the third readings by dividing the reading of electric voltage of the third readings by the reading of electric current of the third readings.

The instant disclosure still deals with any of the aforementioned valves (1), wherein the controller (15) is configured to:

calculate a first impedance value from the first readings by dividing the reading of electric voltage of the first readings by the reading of electric current of the first readings;
calculate a second impedance value from the second readings by dividing the reading of electric voltage of the second readings by the reading of electric current of the second readings; and
calculate a third impedance value from the third readings by dividing the reading of electric voltage of the third readings by the reading of electric current of the third readings.

The instant disclosure also deals with any of the aforementioned valves (1), the valve (1) comprising a power source (12) electrically connected to the winding (9a, 9b) of the actuator (7, 8, 9a, 9b) and in operative communication with the controller (15), wherein the controller (15) is configured to:

send a first power signal to the power source (12), the first power signal causing the power source (12) to apply the electric current of the first readings through and the electric voltage of the first readings to the winding (9a, 9b) of the actuator (7, 8, 9a, 9b) of the valve (1);

after sending the first position signal, send a second power signal to the power source (12), the second power signal causing the power source (12) to apply the electric current of the second readings through and the electric voltage of the second readings to the winding (9a, 9b) of the actuator (7, 8, 9a, 9b) of the valve (1); and

after sending the second position signal, send a third power signal to the power source (12), the third power signal causing the power source (12) to apply the electric current of the third readings through and the electric voltage of the third readings to the winding (9a, 9b) of the actuator (7, 8, 9a, 9b) of the valve (1).

The present disclosure also deals with any of the aforementioned valves (1), wherein the valve (1) comprises a current meter (13) electrically connected in series with the winding (9a, 9b) of the actuator (7, 8, 9a, 9b) of the valve (1) and a voltage meter (14) electrically connected in parallel with the winding (9a, 9b) of the actuator (7, 8, 9a, 9b) of the valve (1), the meters (13, 14) being in operative communication with the controller (15), wherein the controller (15) is configured to:

obtain the first readings of electric current through and of electric voltage applied to the winding (9a, 9b) of the actuator (7, 8, 9a, 9b) of the valve (1) via the current meter (13) and via the voltage meter (14);

after sending the first position signal, obtain the second readings of electric current through and of electric voltage applied to the winding (9a, 9b) of the actuator (7, 8, 9a, 9b) of the valve (1) via the current meter (13) and via the voltage meter (14); and

after sending the second position signal, obtain the third readings of electric current through and of electric voltage applied to the winding (9a, 9b) of the actuator (7, 8, 9a, 9b) of the valve (1) via the current meter (13) and via the voltage meter (14).

The instant disclosure also deals with any of the aforementioned valves (1), wherein the controller (15) is configured to:

after sending the first position signal and while the actuator (7, 8, 9a, 9b) is moving to the first position, obtain the second readings of electric current through and of electric voltage applied to the winding (9a, 9b) of the actuator (7, 8, 9a, 9b) of the valve (1).

The present disclosure still deals with any of the aforementioned valves (1), wherein the controller (15) is configured to:

after sending the second position signal and while the actuator (7, 8, 9a, 9b) is moving to the second position, obtain the third readings of electric current through and of electric voltage applied to the winding (9a, 9b) of the actuator (7, 8, 9a, 9b) of the valve (1).

The present disclosure yet further deals with any of the aforementioned valves (1), wherein the controller (15) is configured to:

after sending the first position signal and while the actuator (7, 8, 9a, 9b) is moving to the first position, obtain the second readings of electric current through and of electric voltage applied to the winding (9a, 9b) of the actuator (7, 8, 9a, 9b) of the valve (1); and

after sending the second position signal and while the actuator (7, 8, 9a, 9b) is moving to the second position, obtain the third readings of electric current through and of electric voltage applied to the winding (9a, 9b) of the actuator (7, 8, 9a, 9b) of the valve (1).

The present disclosure also deals with any of the aforementioned valves (1), wherein the controller (15) is configured to:
estimate the impedance of the winding (9a, 9b) of the actuator (7, 8, 9a, 9b) of the valve (1) by applying a low-pass filter to the first, second, and third impedance values.

The instant disclosure still deals with any of the aforementioned valves (1), wherein the controller (15) is configured to:
estimate the impedance of the winding (9a, 9b) of the actuator (7, 8, 9a, 9b) of the valve (1) by applying a first-order low-pass filter to the first, second, and third impedance values.

The present disclosure also deals with any of the aforementioned valves (1), wherein the controller (15) is configured to:
determine the impedance of the winding (9a, 9b) of the actuator (7, 8, 9a, 9b) of the valve (1) by applying a low-pass filter to the first, second, and third impedance values.

The instant disclosure still deals with any of the aforementioned valves (1), wherein the controller (15) is configured to:
calculate the impedance of the winding (9a, 9b) of the actuator (7, 8, 9a, 9b) of the valve (1) by applying a low-pass filter to the first, second, and third impedance values.

The present disclosure further deals with any of the aforementioned valves (1), wherein the controller (15) is configured to:
determine the impedance of the winding (9a, 9b) of the actuator (7, 8, 9a, 9b) of the valve (1) by applying a first-order low-pass filter to the first, second, and third impedance values.

The instant disclosure still further deals with any of the aforementioned valves (1), wherein the controller (15) is configured to:
calculate the impedance of the winding (9a, 9b) of the actuator (7, 8, 9a, 9b) of the valve (1) by applying a first-order low-pass filter to the first, second, and third impedance values.

The present disclosure also deals with any of the aforementioned valves (1) not explicitly involving a low-pass filter, wherein the controller (15) is configured to:
estimate the impedance of the winding (9a, 9b) of the actuator (7, 8, 9a, 9b) of the valve (1) by applying a moving average filter to the first, second, and third impedance values.

The instant disclosure still deals with any of the aforementioned valves (1) not explicitly involving a low-pass filter, wherein the controller (15) is configured to:
estimate the impedance of the winding (9a, 9b) of the actuator (7, 8, 9a, 9b) of the valve (1) by applying a simple moving average filter to the first, second, and third impedance values.

The present disclosure also deals with any of the aforementioned valves (1) not explicitly involving a low-pass filter, wherein the controller (15) is configured to:
determine the impedance of the winding (9a, 9b) of the actuator (7, 8, 9a, 9b) of the valve (1) by applying a moving average filter to the first, second, and third impedance values.

The instant disclosure still deals with any of the aforementioned valves (1) not explicitly involving a low-pass filter, wherein the controller (15) is configured to:
calculate the impedance of the winding (9a, 9b) of the actuator (7, 8, 9a, 9b) of the valve (1) by applying a moving average filter to the first, second, and third impedance values.

The present disclosure further deals with any of the aforementioned valves (1) not explicitly involving a low-pass filter, wherein the controller (15) is configured to:
determine the impedance of the winding (9a, 9b) of the actuator (7, 8, 9a, 9b) of the valve (1) by applying a simple moving average filter to the first, second, and third impedance values.

The instant disclosure still further deals with any of the aforementioned valves (1) not explicitly involving a low-pass filter, wherein the controller (15) is configured to:
calculate the impedance of the winding (9a, 9b) of the actuator (7, 8, 9a, 9b) of the valve (1) by applying a simple moving average filter to the first, second, and third impedance values.

The instant disclosure still deals with any of the aforementioned valves (1), wherein the controller (15) comprises an application-specific integrated circuit for estimating moving averages and is configured to:
use the application-specific integrated circuit to estimate the impedance of the winding (9a, 9b) of the actuator (7, 8, 9a, 9b) of the valve (1) by applying a moving average filter to the first, second, and third impedance values.

The instant disclosure still deals with any of the aforementioned valves (1) not explicitly involving a low-pass filter, wherein the controller (15) comprises an application-specific integrated circuit for estimating simple moving averages and is configured to:
use the application-specific integrated circuit to estimate the impedance of the winding (9a, 9b) of the actuator (7, 8, 9a, 9b) of the valve (1) by applying a simple moving average filter to the first, second, and third impedance values.

The present disclosure also deals with any of the aforementioned valves (1) not explicitly involving a low-pass filter, wherein the controller (15) comprises an application-specific integrated circuit for determining moving averages and is configured to:
use the application-specific integrated circuit to determine the impedance of the winding (9a, 9b) of the actuator (7, 8, 9a, 9b) of the valve (1) by applying a moving average filter to the first, second, and third impedance values.

The instant disclosure still deals with any of the aforementioned valves (1) not explicitly involving a low-pass filter, wherein the controller (15) comprises an application-specific integrated circuit for calculating moving averages and is configured to:
use the application-specific integrated circuit to calculate the impedance of the winding (9a, 9b) of the actuator (7, 8, 9a, 9b) of the valve (1) by applying a moving average filter to the first, second, and third impedance values.

The present disclosure further deals with any of the aforementioned valves (1) not explicitly involving a low-pass filter, wherein the controller (15) comprises an application-specific integrated circuit for determining simple moving averages and is configured to:
use the application-specific integrated circuit to determine the impedance of the winding (9a, 9b) of the actuator (7, 8, 9a, 9b) of the valve (1) by applying a simple moving average filter to the first, second, and third impedance values.

The instant disclosure still further deals with any of the aforementioned valves (1) not explicitly involving a low-pass filter, wherein the controller (15) comprises an application-specific integrated circuit for calculating simple moving averages and is configured to:
use the application-specific integrated circuit to calculate the impedance of the winding (9a, 9b) of the actuator (7, 8, 9a, 9b) of the valve (1) by applying a simple moving average filter to the first, second, and third impedance values.

The present disclosure also deals with any of the aforementioned valves (1), wherein the valve (1) comprises an electric switch electrically connected to the actuator (7, 8, 9a, 9b) and being in operative communication with the controller (15), wherein the controller (15) is configured to:

compare the impedance of the winding (9a, 9b) of the actuator (7, 8, 9a, 9b) of the valve (1) to a threshold value; and
if the impedance of the winding (9a, 9b) of the actuator (7, 8, 9a, 9b) of the valve (1) is larger than the threshold value:
send a break signal to the switch, the break signal causing the switch to interrupt supply of electric power to the actuator (7, 8, 9a, 9b) of the valve (1).

The instant disclosure still deals with any of the aforementioned valves (1), wherein the valve (1) comprises an electric switch electrically connected to the actuator (7, 8, 9a, 9b) and being in operative communication with the controller (15), wherein the controller (15) is configured to:

compare the impedance of the winding (9a, 9b) of the actuator (7, 8, 9a, 9b) of the valve (1) to a predetermined threshold value; and
if the impedance of the winding (9a, 9b) of the actuator (7, 8, 9a, 9b) of the valve (1) is larger than the predetermined threshold value:
send a break signal to the switch, the break signal causing the switch to interrupt supply of electric power to the actuator (7, 8, 9a, 9b) of the valve (1).

The present disclosure also deals with any of the aforementioned valves (1), wherein the valve (1) comprises an electric switch electrically connected to the winding (9a, 9b) of the actuator (7, 8, 9a, 9b) and being in operative communication with the controller (15), wherein the controller (15) is configured to:

compare the impedance of the winding (9a, 9b) of the actuator (7, 8, 9a, 9b) of the valve (1) to a threshold value; and
if the impedance of the winding (9a, 9b) of the actuator (7, 8, 9a, 9b) of the valve (1) is larger than the threshold value:
send a break signal to the switch, the break signal causing the switch to interrupt supply of electric power to the winding (9a, 9b) of the actuator (7, 8, 9a, 9b) of the valve (1).

The instant disclosure further deals with any of the aforementioned valves (1), wherein the valve (1) comprises an electric switch electrically connected to the winding (9a, 9b) of the actuator (7, 8, 9a, 9b) and being in operative communication with the controller (15), wherein the controller (15) is configured to:

compare the impedance of the winding (9a, 9b) of the actuator (7, 8, 9a, 9b) of the valve (1) to a predetermined threshold value; and
if the impedance of the winding (9a, 9b) of the actuator (7, 8, 9a, 9b) of the valve (1) is larger than the predetermined threshold value:
send a break signal to the switch, the break signal causing the switch to interrupt supply of electric power to the winding (9a, 9b) of the actuator (7, 8, 9a, 9b) of the valve (1).

The present disclosure also deals with a computer program comprising instructions to cause the controller (15) of any of the aforementioned valves (1) to execute the steps of any of the aforementioned methods.
The instant disclosure also deals with a computer program product comprising instructions to cause the controller (15) of any of the aforementioned valves (1) to execute the steps of any of the aforementioned methods.
The present disclosure also deals with a computer-readable data carrier having stored thereon any of the aforementioned computer programs.
The instant disclosure also deals with a computer-readable data carrier having stored thereon any of the aforementioned computer program products.
It should be understood that the foregoing relates only to certain embodiments of the disclosure. Numerous changes can be made therein without departing from the scope of the disclosure as defined by the following claims. It should also be understood that the disclosure is not restricted to the illustrated embodiments. Various modifications can be made within the scope of the claims.

Reference numerals

1 valve
2 housing
3 port
4 port
5 valve member
6 seat
7 armature
8 stem
9a, 9b winding
10 chamber
11 resilient member
12 source
13 first meter
14 second meter
15 controller

**Claims**

1. A method of estimating an impedance of a winding (9a, 9b) inside an actuator (7, 8, 9a, 9b) of a valve (1), the method comprising the steps of:

   obtaining first readings of electric current through and of electric voltage applied to the actuator (7, 8, 9a, 9b) of the valve (1);
   after obtaining the first readings, sending a first position signal to the actuator (7, 8, 9a, 9b) of the valve (1), the first position signal causing the actuator (7, 8, 9a, 9b) to move to a first position;
   after sending the first position signal, obtaining second readings of electric current through and of electric voltage applied to the actuator (7, 8, 9a, 9b) of the valve (1);
   after obtaining the second readings, sending a second position signal to the actuator (7, 8, 9a, 9b) of the valve (1), the second position signal causing the actuator (7, 8, 9a, 9b) to move to a second position;
   after sending the second position signal, obtaining third readings of electric current through and of electric voltage applied to the actuator (7, 8, 9a, 9b) of the valve (1);
   producing a first impedance value from the first readings;
   producing a second impedance value from the second readings;
   producing a third impedance value from the third readings; and
   estimating an impedance of the winding (9a, 9b) inside the actuator (7, 8, 9a, 9b) of the valve (1) by applying a filter to the first, second, and third impedance values.

2. The method according to claim 1, the method comprising the step of:
   after sending the first position signal and while the actuator (7, 8, 9a, 9b) is moving to the first position, obtaining the second readings of electric current through and of electric voltage applied to the actuator (7, 8, 9a, 9b) of the valve (1).

3. The method according to any of the claims 1 to 2, the method comprising the step of:
   estimating the impedance of the winding (9a, 9b) inside the actuator (7, 8, 9a, 9b) of the valve (1) by applying a low-pass filter to the first, second, and third impedance values.

4. The method according to any of the claims 1 to 2, the method comprising the step of:
   estimating the impedance of the winding (9a, 9b) inside the actuator (7, 8, 9a, 9b) of the valve (1) by applying a moving average filter to the first, second, and third impedance values.

5. The method according to any of the claims 1 to 4, the method comprising the steps of:

   comparing the impedance of the winding (9a, 9b) inside the actuator (7, 8, 9a, 9b) of the valve (1) to a threshold value; and
   if the impedance of the winding (9a, 9b) inside the actuator (7, 8, 9a, 9b) of the valve (1) is larger than the threshold value:
   interrupting supply of electric power to the actuator (7, 8, 9a, 9b) of the valve (1).

6. A valve (1) comprising an actuator (7, 8, 9a, 9b) having a winding (9a, 9b), a valve member (5) mechanically coupled to the actuator (7, 8, 9a, 9b), a controller (15) in operative communication with the actuator (7, 8, 9a, 9b), wherein the controller (15) is configured to:

   obtain first readings of electric current through and of electric voltage applied to the winding (9a, 9b) of the actuator (7, 8, 9a, 9b) of the valve (1);
   after obtaining the first readings, send a first position signal to the actuator (7, 8, 9a, 9b) of the valve (1), the first position signal causing the actuator (7, 8, 9a, 9b) to move to a first position;
   after sending the first position signal, obtain second readings of electric current through and of electric voltage applied to the winding (9a, 9b) of the actuator (7, 8, 9a, 9b) of the valve (1);
   after obtaining the second readings, send a second position signal to the actuator (7, 8, 9a, 9b) of the valve (1), the second position signal causing the actuator (7, 8, 9a, 9b) to move to a second position;
   after sending the second position signal, obtain third readings of electric current through and of electric voltage applied to the winding (9a, 9b) of the actuator (7, 8, 9a, 9b) of the valve (1);
   produce a first impedance value from the first readings;
   produce a second impedance value from the second readings;
   produce a third impedance value from the third readings; and
   estimate an impedance of the winding (9a, 9b) of the actuator (7, 8, 9a, 9b) of the valve (1) by applying a filter to the first, second, and third impedance values.

7. The valve (1) according to claim 6, the valve (1) comprising a power source (12) electrically connected to the winding (9a, 9b) of the actuator (7, 8, 9a, 9b) and in operative communication with the controller (15), wherein the controller (15) is configured to:

   send a first power signal to the power source (12), the first power signal causing the power source (12) to apply the electric current of the first readings through and the electric voltage of the first readings to the winding (9a, 9b) of the actuator (7, 8, 9a, 9b) of the valve (1);

after sending the first position signal, send a second power signal to the power source (12), the second power signal causing the power source (12) to apply the electric current of the second readings through and the electric voltage of the second readings to the winding (9a, 9b) of the actuator (7, 8, 9a, 9b) of the valve (1); and

after sending the second position signal, send a third power signal to the power source (12), the third power signal causing the power source (12) to apply the electric current of the third readings through and the electric voltage of the third readings to the winding (9a, 9b) of the actuator (7, 8, 9a, 9b) of the valve (1).

8. The valve (1) according to any of the claims 6 to 7, wherein the valve (1) comprises a current meter (13) electrically connected in series with the winding (9a, 9b) of the actuator (7, 8, 9a, 9b) of the valve (1) and a voltage meter (14) electrically connected in parallel with the winding (9a, 9b) of the actuator (7, 8, 9a, 9b) of the valve (1), the meters (13, 14) being in operative communication with the controller (15), wherein the controller (15) is configured to:

obtain the first readings of electric current through and of electric voltage applied to the winding (9a, 9b) of the actuator (7, 8, 9a, 9b) of the valve (1) via the current meter (13) and via the voltage meter (14);

after sending the first position signal, obtain the second readings of electric current through and of electric voltage applied to the winding (9a, 9b) of the actuator (7, 8, 9a, 9b) of the valve (1) via the current meter (13) and via the voltage meter (14); and

after sending the second position signal, obtain the third readings of electric current through and of electric voltage applied to the winding (9a, 9b) of the actuator (7, 8, 9a, 9b) of the valve (1) via the current meter (13) and via the voltage meter (14).

9. The valve (1) according to any of the claims 6 to 8, wherein the controller (15) is configured to:
after sending the first position signal and while the actuator (7, 8, 9a, 9b) is moving to the first position, obtain the second readings of electric current through and of electric voltage applied to the winding (9a, 9b) of the actuator (7, 8, 9a, 9b) of the valve (1).

10. The valve (1) according to any of the claims 6 to 9, wherein the controller (15) is configured to:
estimate the impedance of the winding (9a, 9b) of the actuator (7, 8, 9a, 9b) of the valve (1) by applying a low-pass filter to the first, second, and third impedance values.

11. The valve (1) according to any of the claims 6 to 9, wherein the controller (15) is configured to:
estimate the impedance of the winding (9a, 9b) of the actuator (7, 8, 9a, 9b) of the valve (1) by applying a moving average filter to the first, second, and third impedance values.

12. The valve (1) according to claim 11, wherein the controller (15) comprises an application-specific integrated circuit for estimating moving averages and is configured to:
use the application-specific integrated circuit to estimate the impedance of the winding (9a, 9b) of the actuator (7, 8, 9a, 9b) of the valve (1) by applying a moving average filter to the first, second, and third impedance values.

13. The valve (1) according to any of the claims 6 to 12, wherein the valve (1) comprises an electric switch electrically connected to the actuator (7, 8, 9a, 9b) and being in operative communication with the controller (15), wherein the controller (15) is configured to:

compare the impedance of the winding (9a, 9b) of the actuator (7, 8, 9a, 9b) of the valve (1) to a threshold value; and
if the impedance of the winding (9a, 9b) of the actuator (7, 8, 9a, 9b) of the valve (1) is larger than the threshold value:
send a break signal to the switch, the break signal causing the switch to interrupt supply of electric power to the actuator (7, 8, 9a, 9b) of the valve (1).

14. A computer program comprising instructions to cause the controller (15) of the valve (1) of claim 6 to execute the steps of any of the methods according to any of the claims 1 to 5.

15. A computer-readable data carrier having stored thereon the computer program of claim 14.

FIG 1

FIG 2

9a, 9b

13

14

12

FIG 3

EP 4 328 606 A1

Europäisches
Patentamt

European
Patent Office

Office européen
des brevets

## EUROPEAN SEARCH REPORT

Application Number

EP 22 19 2185

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2021/404577 A1 (FERRARINI DARIO [IT] ET AL) 30 December 2021 (2021-12-30) * paragraphs [0031] – [0119]; claims 1-18; figures 1-9 * | 1-15 | INV. G01R31/72 F16K31/02 F16K37/00 |
| X | JP 2006 250203 A (DENSO CORP) 21 September 2006 (2006-09-21) * paragraphs [0004] – [0042]; claims 1-4; figures 1-6 * | 1-15 | |
| A | DE 10 2015 104108 A1 (GM GLOBAL TECH OPERATIONS INC [US]) 24 September 2015 (2015-09-24) * paragraphs [0013] – [0039]; claims 1-10; figures 1-4 * | 1-15 | |
| A | EP 1 903 201 B1 (DELPHI INT OPERATIONS LUXEMBOURG SARL [LU]) 12 April 2017 (2017-04-12) * paragraphs [0048] – [0095]; claims 1-23; figures 1-10 * | 1-15 | TECHNICAL FIELDS SEARCHED (IPC) G01R F16K |

The present search report has been drawn up for all claims

| Place of search | Date of completion of the search | Examiner |
|---|---|---|
| Munich | 11 February 2023 | Bilzer, Claus |

EPO FORM 1503 03.82 (P04C01)

**EP 4 328 606 A1**

## ANNEX TO THE EUROPEAN SEARCH REPORT
## ON EUROPEAN PATENT APPLICATION NO.

EP 22 19 2185

11-02-2023

| Patent document cited in search report | | Publication date | Patent family member(s) | | Publication date |
|---|---|---|---|---|---|
| US 2021404577 | A1 | 30-12-2021 | CN 110914933 | A | 24-03-2020 |
| | | | EP 3676860 | A1 | 08-07-2020 |
| | | | US 2021404577 | A1 | 30-12-2021 |
| | | | WO 2019043572 | A1 | 07-03-2019 |
| JP 2006250203 | A | 21-09-2006 | NONE | | |
| DE 102015104108 | A1 | 24-09-2015 | CN 104931791 | A | 23-09-2015 |
| | | | DE 102015104108 | A1 | 24-09-2015 |
| EP 1903201 | B1 | 12-04-2017 | NONE | | |

EPO FORM P0459

**EP 4 328 606 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H03147532 A